# EUROPEAN PATENT APPLICATION

(11) **EP 4 671 785 A1**
(43) Date of publication of application: **31.12.2025**
(21) Application number: 23938219.5
(22) Date of filing: 02.11.2023
(51) Int. Cl.: G01R 31/367, G01R 31/385

(54) **HIGH-EFFICIENCY CAPACITY GRADING METHOD AND SYSTEM FOR LITHIUM ION BATTERIES AND STORAGE MEDIUM**

(30) Priority: 22.05.2023 CN 202310595731; 17.10.2023 CN 202311345263
(71) Applicant: Hefei Gotion High-Tech Power Energy Co., Ltd., Hefei, Anhui 230012 (CN)
(72) Inventor: WU, Yangyang, Hefei, Anhui 230012 (CN); LI, Tao, Hefei, Anhui 230012 (CN); WU, Qinqin, Hefei, Anhui 230012 (CN)
(74) Representative: Sun, Yiming
(86) International application number: PCT/CN2023/129265
(87) International publication number: WO 2024/239551

(57) **Abstract**

The present disclosure provides a high-efficiency grading method and system for lithium-ion cells, and a storage medium, and belongs to the technical field of lithium-ion battery manufacturing. The present disclosure aims to solve the problem of excessively long capacity grading time for lithium-ion cells. The high-efficiency grading method includes: obtaining discharge capacities C₁, discharge endpoint voltages V₁, rebound voltages V₂, and remaining capacities C₂ of lithium-ion cells; subjecting data of the obtained discharge capacities C₁ or discharge endpoint voltages V₁ to slicing and classification processing; plotting a scatter plot of the remaining capacities C₂ against the rebound voltages V₂ according to the remaining capacities C₂ and corresponding rebound voltages V₂ of the lithium-ion cells, performing curve fitting, and deriving remaining capacity prediction model equations; and calculating full discharge capacities of a new batch of lithium-ion cells. The present disclosure omits the full discharge step in the conventional grading process, greatly shortening the capacity grading time, improving production efficiency, reducing hardware investment and energy consumption during capacity grading, and lowering battery manufacturing costs.

## Description

### TECHNICAL FIELD

The present disclosure belongs to the technical field of lithium-ion battery manufacturing, and relates to a high-efficiency grading method and system for lithium-ion cells, and a storage medium.

### BACKGROUND TECHNOLOGY

Lithium-ion batteries, emerging in the early 1990s, represent a novel environmentally friendly electrochemical power source. They offer high voltage, high specific energy, stable discharge voltage, good cycle performance, excellent safety performance, and long storage and service life. Therefore, lithium-ion power batteries are currently one of the latest development directions in the electrochemical power source industry.

Capacity is a critical performance metric for lithium-ion batteries. In practical use, multiple individual lithium-ion cells are connected in series and parallel to form modules and battery packs. Cell capacity must be determined prior to module or pack assembly. Currently, the grading process for lithium-ion cells mainly adopts a mode of full charge + full discharge + recharge to a specified state of charge (SOC). That is, the cells undergo constant current constant voltage charging method to a full SOC (100% SOC), constant current discharging to a minimum discharge voltage, and recharging to a specified SOC sequentially. The capacity discharged during the discharge process is the cell capacity. Subsequent cell sorting and capacity matching are based on the cell capacity. However, the capacity grading time of the above process is over 4 h, even reaching 6-7 h, severely constraining the capacity grading productivity improvement for battery manufacturers. Meanwhile, the too long grading time increases the cost investment in capacity grading. Currently, the charge/discharge rate for capacity grading reaches 0.6-1.0 C, leaving no room for further increase.

In the prior art, Chinese patent application CN112034367A, published on December 4, 2020, discloses a lithium-ion cell capacity prediction method and system. The disclosure compensates the predicted discharge capacity Y1 based on the relationship curve between the charging temperature T2 and capacity. This technical solution primarily addresses the influence of temperature on the predicted discharge capacity. Although this technical solution saves some charge/discharge time for capacity grading and reduces battery manufacturing costs to a certain extent, it still suffers from the problem of excessively long capacity grading time.

### CONTENT OF THE INVENTION

The present disclosure aims to solve the problem of excessively long capacity grading time for lithium-ion cells.

The present disclosure solves the technical problem through following technical solutions:
A high-efficiency grading method for lithium-ion cells includes following steps:
S1: obtaining discharge capacities C₁, discharge endpoint voltages V₁, rebound voltages V₂, and remaining capacities C₂ of lithium-ion cells;
S2: subjecting data of the discharge capacities C₁ obtained in the step S1 to slicing and classification processing according to a cut-off voltage discharge mode, or subjecting data of the discharge endpoint voltages V₁ obtained in the step S1 to slicing and classification processing according to a cut-off time discharge mode, thereby ensuring consistent starting voltages and rebound times of rebound voltages for each data category;
S3: plotting, based on the data after slicing and classification, a scatter plot of the remaining capacities C₂ against the rebound voltages V₂ according to the remaining capacities C₂ and corresponding rebound voltages V₂ of the lithium-ion cells within each interval, performing curve fitting on the scatter plot, and deriving remaining capacity prediction model equations for the lithium-ion cells within each interval; and
S4: calculating full discharge capacities of a new batch of lithium-ion cells based on a remaining capacity prediction model constructed in the step S3.

Furthermore, the S1: obtaining discharge capacities C₁, discharge endpoint voltages V₁, rebound voltages V₂, and remaining capacities C₂ of lithium-ion cells is implemented through a grading process including following steps:
S11: subjecting the lithium-ion cells to constant current constant voltage charging method at a rate of 0.3-1.0 C to a full state of charge (SOC);
S12: allowing the lithium-ion cells with a full SOC to rest for 3-10 min;
S13: subjecting the lithium-ion cells to constant current discharging at a rate of 0.5-1.0 C to a specified SOC, and recording the discharge capacities C₁ and the discharge endpoint voltages V₁ of the lithium-ion cells;
S14: allowing the lithium-ion cells to rest for 1-10 min, and measuring and recording voltages of the lithium-ion cells after resting as the rebound voltages V₂;
S15: subjecting the lithium-ion cells to constant current discharging at a rate of 0.5-1.0 C to a specified voltage, and recording discharge capacities of the lithium-ion cells after the discharging as the remaining capacities C₂;
S16: allowing the lithium-ion cells to rest for 5-20 min; and
S17: subjecting the lithium-ion cells after resting to constant current charging at a rate of 0.1-0.5 C to a specified voltage or a specified SOC.

Furthermore, in the step S2, the subjecting data of the discharge capacities C₁ obtained in the step S1 to slicing and classification processing according to a cut-off voltage discharge mode includes:
S21: classifying grading trays into multiple intervals according to maximum discharge capacities within the grading trays; and
S22: classifying the lithium-ion cells within each of the grading tray intervals generated in the step S21 into multiple sub-intervals according to capacities of the lithium-ion cells.

Furthermore, the S21: classifying grading trays into multiple intervals according to maximum discharge capacities within the grading trays includes: denoting, for m grading trays, a maximum discharge capacity within a 1^{st} grading tray as C₁ₘₐₓ₋₁, a maximum discharge capacity within a 2^{nd} grading tray as C₁ₘₐₓ₋₂, and so on, with a maximum discharge capacity within an m-th grading tray denoted as C₁ₘₐₓ₋ₘ; arranging the maximum discharge capacities C₁ₘₐₓ₋₁, C₁ₘₐₓ₋₂, ..., C₁ₘₐₓ₋ₘ in a queue in ascending or descending order; and classifying, by taking a head of the queue as a benchmark, grading trays with a difference of 0-x mAh from the head into a first interval, grading trays with a difference of x-2x mAh from the head into a second interval, and so on, thereby generating multiple intervals, such that the m grading trays are classified into multiple intervals according to the maximum discharge capacities within the grading trays, and a difference in the maximum discharge capacities among the grading trays within each interval is controlled within x mAh, ensuring consistency among the grading trays.

Furthermore, the S22: classifying the lithium-ion cells within each of the grading tray intervals generated in the step S21 into multiple sub-intervals according to capacities of the lithium-ion cells includes: calculating a total number of lithium-ion cells within a certain interval generated in the step S21 as n*p, assuming that the grading trays each hold n lithium-ion cells and the interval includes p trays; denoting the capacity of a 1^{st} lithium-ion cell as C₁₋₁, the capacity of a 2^{nd} lithium-ion cell as C₁₋₂, and so on, with the capacity of an (n*p)-th lithium-ion cell denoted as C_{1-n*p}; arranging the capacities C₁₋₁, C₁₋₂, ..., C_{1-n*p} in a queue in ascending or descending order; and classifying, by taking a head of the queue as a benchmark, lithium-ion cells with a difference of 0-y mAh from the head into a first sub-interval, lithium-ion cells with a difference of y-2y mAh from the head into a second sub-interval, and so on, thereby generating multiple sub-intervals, such that the n*p lithium-ion cells are classified into multiple sub-intervals, and a difference in the capacities among the lithium-ion cells within each sub-interval is controlled within y mAh, ensuring consistency of individual lithium-ion cells.

Furthermore, in the step S2, the subjecting data of discharge endpoint voltages V₁ obtained in the step S1 to slicing and classification processing according to a cut-off time discharge mode includes: denoting, for N lithium-ion cells, the discharge endpoint voltage of a 1^{st} lithium-ion cell as V₁₋₁, the discharge endpoint voltage of a 2^{nd} lithium-ion cell as V₁₋₂, and so on, with the discharge endpoint voltage of an N-th lithium-ion cell denoted as V_{1-N}; arranging the discharge endpoint voltages in a queue in ascending or descending order; and classifying, by taking a head of the queue as a benchmark, lithium-ion cells with a difference of 0-s mV from the head into a first interval, lithium-ion cells with a difference of s-2s mV from the head into a second interval, and so on, thereby generating multiple intervals, such that the N lithium-ion cells are classified into multiple intervals according to the discharge endpoint voltages, and a difference in the discharge endpoint voltages among the lithium-ion cells within each interval is controlled within s mV, ensuring consistency of the lithium-ion cells.

Furthermore, the S4: calculating full discharge capacities of a new batch of lithium-ion cells based on a remaining capacity prediction model constructed in the step S3 includes:
S41: obtaining discharge capacities C₁ and rebound voltages V₂ of the new batch of lithium-ion cells according to the steps S11 to S14 of the grading process in the step S1;
S42: subjecting data of the obtained discharge capacities C₁ of the new batch of lithium-ion cells to slicing and classification processing according to the step S2, and retrieving corresponding calculation equations from the remaining capacity prediction model for each data category;
S43: inputting the rebound voltages V2 obtained in the step S41 into the calculation equations retrieved in the step S42, and calculating remaining capacities C₂ of the new batch of lithium-ion cells; and
S44: deriving an equation as follows: full discharge capacity C of new-batch lithium-ion cell = discharge capacity C₁ of new-batch lithium-ion cell + remaining capacity C₂ of new-batch lithium-ion cell.

Furthermore, the S4: calculating full discharge capacities of a new batch of lithium-ion cells based on a remaining capacity prediction model constructed in the step S3 includes:
S4-1: obtaining discharge endpoint voltages V₁ and rebound voltages V₂ of the new batch of lithium-ion cells according to the steps S11 to S14 of the grading process in the step S1;
S4-2: subjecting data of the obtained discharge endpoint voltages V₁ of the new batch of lithium-ion cells to slicing and classification processing according to the step S2, and retrieving corresponding calculation equations from the remaining capacity prediction model for each data category;
S4-3: inputting the rebound voltages V₂ obtained in the step S4-1 into the calculation equations retrieved in the step S4-2, and calculating remaining capacities C₂ of the new batch of lithium-ion cells; and
S4-4: deriving an equation as follows: full discharge capacity C of new-batch lithium-ion cell = discharge capacity C₁ of new-batch lithium-ion cell + remaining capacity C₂ of new-batch lithium-ion cell.

Furthermore, in the step S3, the remaining capacity prediction model equations are monomial or polynomial.

Furthermore, the lithium-ion cell includes a lithium iron phosphate (LFP) cell and a nickel cobalt manganese (NCM) cell in terms of cell composition, and includes a square cell, a cylindrical cell, and a pouch cell in terms of cell type.

A high-efficiency grading system for lithium-ion cells includes: a data acquisition module, a slicing and classification processing module, a prediction model construction module, and a full discharge capacity calculation module, where
the data acquisition module is configured to acquire discharge capacities C₁, discharge endpoint voltages V₁, rebound voltages V₂, and remaining capacities C₂ of lithium-ion cells;
the slicing and classification processing module is configured to subject data of the obtained discharge capacities C₁ to slicing and classification processing according to a cut-off voltage discharge mode or subject data of the discharge endpoint voltage V₁ obtained by the data acquisition module to slicing and classification processing according to a cut-off time discharge mode, thereby ensuring consistent starting voltages and rebound times of rebound voltages for each data category;
the prediction model construction module is configured to plot, based on the data after slicing and classification, a scatter plot of the remaining capacities C₂ against the rebound voltages V₂ according to the remaining capacities C₂ and corresponding rebound voltages V₂ of the lithium-ion cells within each interval, perform curve fitting on the scatter plot, and derive remaining capacity prediction model equations for the lithium-ion cells within each interval; and
the full discharge capacity calculation module is configured to calculate full discharge capacities of a new batch of lithium-ion cells based on a remaining capacity prediction model.

Furthermore, the data acquisition module is configured to acquire the discharge capacities C₁, the discharge endpoint voltages V₁, the rebound voltages V₂, and the remaining capacities C₂ of the lithium-ion cells through a grading process including following steps:
S11: subjecting the lithium-ion cells to constant current constant voltage charging method at a rate of 0.3-1.0 C to a full SOC;
S12: allowing the lithium-ion cells with a full SOC to rest for 3-10 min;
S13: subjecting the lithium-ion cells to constant current discharging at a rate of 0.5-1.0 C to a specified SOC, and recording the discharge capacities C₁ and the discharge endpoint voltages V₁ of the lithium-ion cells;
S14: allowing the lithium-ion cells to rest for 1-10 min, and measuring and recording voltages of the lithium-ion cells after resting as the rebound voltages V₂;
S15: subjecting the lithium-ion cells to constant current discharging at a rate of 0.5-1.0 C to a specified voltage, and recording discharge capacities of the lithium-ion cells after the discharging as the remaining capacities C₂;
S16: allowing the lithium-ion cells to rest for 5-20 min; and
S17: subjecting the lithium-ion cells after resting to constant current charging at a rate of 0.1-0.5 C to a specified voltage or a specified SOC.

Furthermore, the slicing and classification processing module is configured to subject data of the obtained discharge capacities C₁ to the slicing and classification processing according to the cut-off voltage discharge mode through following steps:
S21: classifying grading trays into multiple intervals according to maximum discharge capacities within the grading trays, specifically as follows: denoting, for m grading trays, a maximum discharge capacity within a 1^{st} grading tray as C₁ₘₐₓ₋₁, a maximum discharge capacity within a 2^{nd} grading tray as C₁ₘₐₓ₋₂, and so on, with a maximum discharge capacity within an m-th grading tray denoted as C₁ₘₐₓ₋ₘ; arranging the maximum discharge capacities C₁ₘₐₓ₋₁, C₁ₘₐₓ₋₂, ..., C₁ₘₐₓ₋ₘ in a queue in ascending or descending order; and classifying, by taking a head of the queue as a benchmark, grading trays with a difference of 0-x mAh from the head into a first interval, grading trays with a difference of x-2x mAh from the head into a second interval, and so on, thereby generating multiple intervals, such that the m grading trays are classified into multiple intervals according to the maximum discharge capacities within the grading trays, and a difference in the maximum discharge capacities among the grading trays within each interval is controlled within x mAh, ensuring consistency among the grading trays; and
S22: classifying the lithium-ion cells within each of the grading tray intervals generated in the step S21 into multiple sub-intervals according to capacities of the lithium-ion cells, specifically as follows: calculating a total number of lithium-ion cells within a certain interval generated in the step S21 as n*p, assuming that the grading trays each hold n lithium-ion cells and the interval includes p trays; denoting the capacity of a 1^{st} lithium-ion cell as C₁₋₁, the capacity of a 2^{nd} lithium-ion cell as C₁₋₂, and so on, with the capacity of an (n*p)-th lithium-ion cell denoted as C_{1-n*p}; arranging the capacities C₁₋₁, C₁₋₂, ..., C_{1-n*p} in a queue in ascending or descending order; and classifying, by taking a head of the queue as a benchmark, lithium-ion cells with a difference of 0-y mAh from the head into a first sub-interval, lithium-ion cells with a difference of y-2y mAh from the head into a second sub-interval, and so on, thereby generating multiple sub-intervals, such that the n*p lithium-ion cells are classified into multiple sub-intervals, and a difference in the capacities among the lithium-ion cells within each sub-interval is controlled within y mAh, ensuring consistency of individual lithium-ion cells.

Furthermore, the slicing and classification processing module is configured to subject data of the obtained discharge endpoint voltages V₁ to the slicing and classification processing according to the cut-off time discharge mode through following steps: denoting, for N lithium-ion cells, the discharge endpoint voltage of a 1^{st} lithium-ion cell as V₁₋₁, the discharge endpoint voltage of a 2^{nd} lithium-ion cell as V₁₋₂, and so on, with the discharge endpoint voltage of an N-th lithium-ion cell denoted as V_{1-N}; arranging the discharge endpoint voltages in a queue in ascending or descending order; and classifying, by taking a head of the queue as a benchmark, lithium-ion cells with a difference of 0-s mV from the head into a first interval, lithium-ion cells with a difference of s-2s mV from the head into a second interval, and so on, thereby generating multiple intervals, such that the N lithium-ion cells are classified into multiple intervals according to the discharge endpoint voltages, and a difference in the discharge endpoint voltages among the lithium-ion cells within each interval is controlled within s mV, ensuring consistency of the lithium-ion cells.

Furthermore, the full discharge capacities of the new batch of lithium-ion cells are calculated based on the remaining capacity prediction model through following steps:
S41: obtaining discharge capacities C₁ and rebound voltages V₂ of the new batch of lithium-ion cells according to the steps S11 to S14 of the grading process in the step S1;
S42: subjecting data of the obtained discharge capacities C₁ of the new batch of lithium-ion cells to slicing and classification processing according to the step S2, and retrieving corresponding calculation equations from the remaining capacity prediction model for each data category;
S43: inputting the rebound voltages V2 obtained in the step S41 into the calculation equations retrieved in the step S42, and calculating remaining capacities C₂ of the new batch of lithium-ion cells; and
S44: deriving an equation as follows: full discharge capacity C of new-batch lithium-ion cell = discharge capacity C₁ of new-batch lithium-ion cell + remaining capacity C₂ of new-batch lithium-ion cell.

Furthermore, the full discharge capacities of the new batch of lithium-ion cells are calculated based on the remaining capacity prediction model through following steps:
S4-1: obtaining discharge endpoint voltages V₁ and rebound voltages V₂ of the new batch of lithium-ion cells according to the steps S11 to S14 of the grading process in the step S1;
S4-2: subjecting data of the obtained discharge endpoint voltages V₁ of the new batch of lithium-ion cells to slicing and classification processing according to the step S2, and retrieving corresponding calculation equations from the remaining capacity prediction model for each data category;
S4-3: inputting the rebound voltages V₂ obtained in the step S4-1 into the calculation equations retrieved in the step S4-2, and calculating remaining capacities C₂ of the new batch of lithium-ion cells; and
S4-4: deriving an equation as follows: full discharge capacity C of new-batch lithium-ion cell = discharge capacity C₁ of new-batch lithium-ion cell + remaining capacity C₂ of new-batch lithium-ion cell.

A storage medium is configured to store a computer program, where the computer program is executed by a processor to implement the above-mentioned high-efficiency grading method for lithium-ion cells.

The present disclosure has following advantages:
The technical solutions of the present disclosure use the remaining capacity prediction model to calculate the full discharge capacity of the new batch of lithium-ion cells, omitting the full discharge step in the conventional grading process, greatly shortening the capacity grading time and improving production efficiency. Additionally, they reduce hardware investment and energy consumption during capacity grading, lowering battery manufacturing costs.

### DESCRIPTION OF THE DRAWINGS

FIG. 1 is a flowchart of a high-efficiency grading method for lithium-ion cells according to the present disclosure;
FIG. 2 is a scatter plot of a remaining capacity versus a rebound voltage according to the present disclosure; and
FIG. 3 is a fitting curve diagram of the remaining capacity versus the rebound voltages according to the present disclosure.

### SPECIFIC IMPLEMENTATIONS

In order to make the objectives, technical solutions, and advantages of embodiments of the present disclosure clearer, the following clearly and completely describes the technical solutions in the embodiments of the present disclosure with reference to the embodiments of the present disclosure. Apparently, the described embodiments are some rather than all of the embodiments. All other embodiments obtained by a person of ordinary skill in the art based on the embodiments of the present disclosure without creative efforts shall fall within the protection scope of the present disclosure.

The technical solutions of the present disclosure will be further described below with reference to accompanying drawings and specific embodiments in the specification.

### Embodiment 1

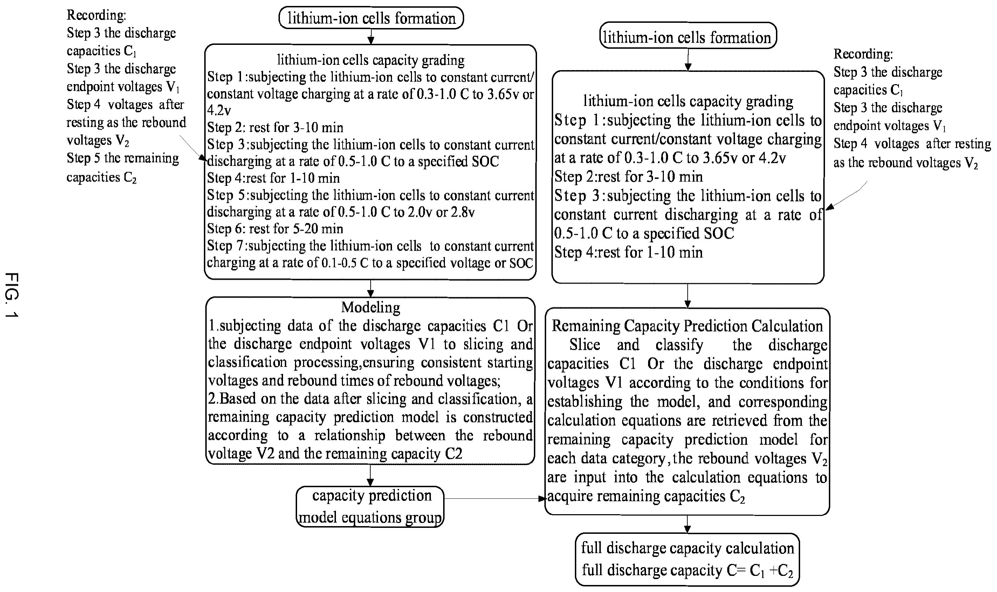

As shown in FIG. 1, this embodiment proposes a high-efficiency grading method for lithium-ion cells, including following steps.

Step 1. Discharge capacities C₁, rebound voltages V₂, and remaining capacities C₂ of lithium-ion cells are obtained.

Taking mass-produced 50 Ah lithium-ion cells as an example, the obtained data volume exceeds 1 million entries, and the grading process used for data acquisition is as follows.
1) The lithium-ion cells are subjected to constant current constant voltage charging method at a rate of 0.3-1.0 C to a full SOC (3.65 V or 4.2 V).
2) The lithium-ion cells with a full SOC rest for 3-10 min.
3) The lithium-ion cells are subjected to constant current discharging at a rate of 0.5-1.0 C to a specified SOC, and the discharge capacity C₁ of the lithium-ion cells is recorded.
4) The lithium-ion cells rest for 1-10 min, and a voltage of the lithium-ion cells after resting is measured and recorded as the rebound voltage V₂.
5) The lithium-ion cells are subjected to constant current discharging at a rate of 0.5-1.0 C to 2.0 V or 2.8 V, and a discharge capacity of the lithium-ion cells after the discharging is recorded as the remaining capacity C₂.
6) The lithium-ion cells rest for 5-20 min.
7) After resting, the lithium-ion cells are subjected to constant current charging at a rate of 0.1-0.5 C to a specified voltage or a specified SOC.

Step 2. Data of the discharge capacity C₁ obtained in the step 1 is subjected to slicing and classification processing according to a cut-off voltage discharge mode to ensure consistent starting voltages and rebound times of rebound voltages for each data category, specifically as follows.
1) Grading trays are classified into multiple intervals according to maximum discharge capacities within the grading trays.
   Assuming there are 1,000 grading trays, each holding 60 lithium-ion cells, totaling 60,000 lithium-ion cells. The maximum discharge capacity within a 1^{st} grading tray is recorded as C₁ₘₐₓ₋₁, the maximum discharge capacity within a 2^{nd} grading tray is recorded as C₁ₘₐₓ₋₂, and so on, with the maximum discharge capacity within a 1,000-th grading tray recorded as C_{1max-1,000}. The discharge capacities C₁ₘₐₓ₋₁, C₁ₘₐₓ₋₂, ..., C_{1max-1,000} are arranged in a queue in ascending or descending order. By taking a head of the queue as a benchmark, grading trays with a difference of 0-200 mAh from the head are classified into a first interval, grading trays with a difference of 200-400 mAh from the head are classified into a second interval, and so on. In this way, there are multiple intervals. That is, the 1,000 grading trays are classified into multiple intervals according to the maximum discharge capacities within the grading trays, and a difference in the maximum discharge capacities among the grading trays within each interval is controlled within 200 mAh, ensuring consistency among the grading trays.
2) The lithium-ion cells within each of the grading tray intervals generated in the step 1) are classified into multiple sub-intervals according to their capacities.

The grading trays each hold 60 lithium-ion cells. Assuming a certain interval in the step (1) includes 10 trays, totaling 600 lithium-ion cells. The capacity of a 1^{st} lithium-ion cell is recorded as C₁₋₁, the capacity of a 2^{nd} lithium-ion cell is recorded as C₁₋₂, and so on, with the capacity of a 600-th lithium-ion cell denoted as C₁₋₆₀₀. The capacities C₁₋₁, C₁₋₂, ..., C₁₋₆₀₀ are arranged in a queue in ascending or descending order. By taking a head of the queue as a benchmark, lithium-ion cells with a difference of 0-400 mAh from the head are classified into a first sub-interval, lithium-ion cells with a difference of 400-800 mAh from the head are classified into a second sub-interval, and so on. In this way, there are multiple sub-intervals. That is, the 600 lithium-ion cells within the interval generated in the step 1) are classified into multiple sub-intervals, and a difference in the capacities among the lithium-ion cells within each sub-interval is controlled within 400 mAh, ensuring consistency of individual lithium-ion cells.

Step 3. Based on the data after slicing and classification, a remaining capacity prediction model is constructed according to a relationship between the rebound voltage V₂ and the remaining capacity C₂, specifically as follows.

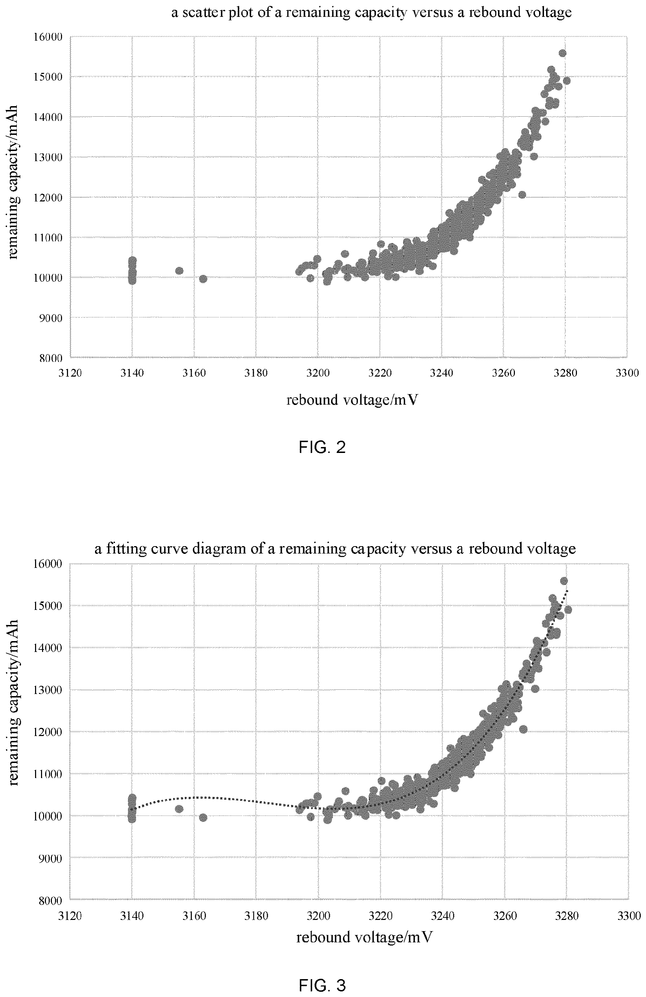

As shown in FIG. 2 and FIG. 3, a scatter plot of the remaining capacities C₂ versus the rebound voltages V₂ is plotted according to the remaining capacities C₂ and the corresponding rebound voltages V₂ for the lithium-ion cells in each sub-interval classified in the item 2) of the step 2. Curve fitting is performed based on the scatter plot to derive remaining capacity prediction model equations for the lithium-ion cells in each sub-interval. Each sub-interval corresponds to one equation, thereby forming an equation group, and the equation may be a monomial or polynomial.

Step 4. Full discharge capacities of a new batch of lithium-ion cells are calculated based on the remaining capacity prediction model constructed in the step 3, specifically as follows.
a) Discharge capacities C₁ and rebound voltages V₂ of the new batch of lithium-ion cells are obtained according to the steps 1) to 4) of the grading process in the step 1.
b) The data of obtained discharge capacities C₁ of the new batch of lithium-ion cells is subjected to slicing and classification processing according to the step 2, and corresponding calculation equations are retrieved from the remaining capacity prediction model for each data category.
c) The rebound voltages V₂ obtained in the step a) are input into the calculation equations retrieved in the step b) to acquire remaining capacities C₂ of the new batch of lithium-ion cells.
d) An equation is derived as follows: full discharge capacity C of new-batch lithium-ion cell = discharge capacity C₁ of new-batch lithium-ion cell + remaining capacity C₂ of new-batch lithium-ion cell.

The high-efficiency grading method for lithium-ion cells in this embodiment uses the remaining capacity prediction model to calculate the full discharge capacity of the new batch of lithium-ion cells, omitting the steps 5) to 7) of the grading process in the step 1, greatly shortening the capacity grading time and improving production efficiency. Additionally, it reduces hardware investment and energy consumption during capacity grading, lowering battery manufacturing costs.

### Embodiment 2

As shown in FIG. 1, this embodiment proposes a high-efficiency grading method for lithium-ion cells, including following steps.

Taking mass-produced 50 Ah lithium-ion cells as an example, the obtained data volume exceeds 1 million entries, and the grading process used for data acquisition is as follows.

Step 1. Discharge endpoint voltages V₁, rebound voltages V₂, and remaining capacities C₂ of lithium-ion cells are obtained.

Taking mass-produced 50 Ah lithium-ion cells as an example, the obtained data volume exceeds 1 million entries, and the grading process used for data acquisition is as follows.
1) The lithium-ion cells are subjected to constant current constant voltage charging method at a rate of 0.3-1.0 C to a full SOC (3.65 V or 4.2 V).
2) The lithium-ion cells with a full SOC rest for 3-10 min.
3) The lithium-ion cells are subjected to constant current discharging at a rate of 0.5-1.0 C to a specified SOC, and the discharge endpoint voltage V₁ of the lithium-ion cells is recorded.
4) The lithium-ion cells rest for 1-10 min, and a voltage of the lithium-ion cells after resting is measured and recorded as the rebound voltage V₂.
5) The lithium-ion cells are subjected to constant current discharging at a rate of 0.5-1.0 C to 2.0 V or 2.8 V, and a discharge capacity of the lithium-ion cells after the discharging is recorded as the remaining capacity C₂.
6) The lithium-ion cells rest for 5-20 min.
7) After resting, the lithium-ion cells are subjected to constant current charging at a rate of 0.1-0.5 C to a specified voltage or a specified SOC.

Step 2. Data of the discharge endpoint voltage V₁ obtained in the step 1 is subjected to slicing and classification processing according to a cut-off time discharge mode to ensure consistent starting voltages and rebound times of rebound voltages for each data category, specifically as follows.

Assuming there are 60,000 lithium-ion cells. The discharge endpoint voltage of a 1^{st} lithium-ion cell is recorded as V₁₋₁, the discharge endpoint voltage of a 2^{nd} lithium-ion cell is recorded as V₁₋₂, and so on, with the discharge endpoint voltage of a 60,000-th lithium-ion cell denoted as V_{1-60,000}. The lithium-ion cells are arranged in a queue in ascending or descending order. By taking a head of the queue as a benchmark, lithium-ion cells with a difference of 0-1 mV from the head are classified into a first interval, lithium-ion cells with a difference of 1-2 mV from the head are classified into a second interval, and so on. In this way, there are multiple intervals. That is, the 60,000 lithium-ion cells are classified into multiple intervals according to the discharge endpoint voltages, and a difference in the discharge endpoint voltages among the lithium-ion cells within each interval is controlled within 1 mV, ensuring consistency of the lithium-ion cells.

Step 3. Based on the data after slicing and classification, a remaining capacity prediction model is constructed according to a relationship between the rebound voltage V₂ and the remaining capacity C₂, specifically as follows.

As shown in FIG. 2 and FIG. 3, a scatter plot of the remaining capacities C₂ versus the rebound voltages V₂ is plotted according to the remaining capacities C₂ and the corresponding rebound voltages V₂ for the lithium-ion cells in each sub-interval classified in the step 2. Curve fitting is performed based on the scatter plot to derive remaining capacity prediction model equations for the lithium-ion cells in each sub-interval. Each sub-interval corresponds to one remaining capacity prediction model equation, and the equation may be a monomial or polynomial.

Step 4. Full discharge capacities of a new batch of lithium-ion cells are calculated based on the remaining capacity prediction model constructed in the step 3, specifically as follows.
a) Discharge endpoint voltages V₁ and rebound voltages V₂ of the new batch of lithium-ion cells are obtained according to the steps 1) to 4) of the grading process in the step 1.
b) The data of the obtained discharge endpoint voltages V₁ of the new batch of lithium-ion cells is subjected to slicing and classification processing according to the step 2, and corresponding calculation equations are retrieved from the remaining capacity prediction model for each data category.
c) The rebound voltages V₂ obtained in the step a) are input into the calculation equations retrieved in the step b) to acquire remaining capacities C₂ of the new batch of lithium-ion cells.
d) An equation is derived as follows: full discharge capacity C of new-batch lithium-ion cell = discharge capacity C₁ of new-batch lithium-ion cell + remaining capacity C₂ of new-batch lithium-ion cell.

The high-efficiency grading method for lithium-ion cells in this embodiment uses the remaining capacity prediction model to calculate the full discharge capacity of the new batch of lithium-ion cells, omitting the steps 5) to 7) of the grading process in the step 1, greatly shortening the capacity grading time and improving production efficiency. Additionally, it reduces hardware investment and energy consumption during capacity grading, lowering battery manufacturing costs.

The lithium-ion cell in Embodiment 1 and Embodiment 2 of the present disclosure includes a lithium iron phosphate (LFP) cell and a nickel cobalt manganese (NCM) cell, and includes a square cell, a cylindrical cell, and a pouch cell in terms of cell type. Test results for Embodiment 1 and Embodiment 2 of the present disclosure are shown in Table 1 below.

**Table 1 Average prediction errors and prediction errors (≤10‰) of test samples**

| | Batch | Sample size (cells) | Average predication error | Proportion with prediction error ≤ 10‰ |
|---|---|---|---|---|
| Embodiment 1 | Batch A | 75684 | 2.374‰ | 99.385% |
| | Batch B | 82120 | 2.419‰ | 99.101% |
| Embodiment 2 | Batch C | 45700 | 2.034‰ | 99.576% |
| | Batch D | 38470 | 2.220‰ | 99.259% |

From Table 1, the application error of the high-efficiency grading method for lithium-ion cells in Embodiment 1 and Embodiment 2 of the present disclosure is controllable, lower than 2.5‰, and the inter-batch error fluctuation is lower than 0.5‰, indicating stable prediction results of the model.

### Embodiment 3

This embodiment provides a high-efficiency grading system for lithium-ion cells. The lithium-ion cell includes a LFP cell and a NCM cell in terms of cell composition, and includes a square cell, a cylindrical cell, and a pouch cell in terms of cell type. The high-efficiency grading system for lithium-ion cells includes: a data acquisition module, a slicing and classification processing module, a prediction model construction module, and a full discharge capacity calculation module.

The data acquisition module is configured to acquire discharge capacities C₁, discharge endpoint voltages V₁, rebound voltages V₂, and remaining capacities C₂ of lithium-ion cells.

A grading process includes following steps.

S11. The lithium-ion cells are subjected to constant current constant voltage charging method at a rate of 0.3-1.0 C to a full SOC.

S12. The lithium-ion cells with a full SOC rest for 3-10 min.

S13. The lithium-ion cells are subjected to constant current discharging at a rate of 0.5-1.0 C to a specified SOC, and the discharge capacity C₁ and the discharge endpoint voltages V₁ of the lithium-ion cells is recorded.

S14. The lithium-ion cells rest for 1-10 min, and a voltage of the lithium-ion cells after resting is measured and recorded as the rebound voltage V₂.

S15. The lithium-ion cells are subjected to constant current discharging at a rate of 0.5-1.0 C to a specified voltage, and a discharge capacity of the lithium-ion cells after the discharging is recorded as the remaining capacity C₂.

S16. The lithium-ion cells rest for 5-20 min.

S17. After resting, the lithium-ion cells are subjected to constant current charging at a rate of 0.1-0.5 C to a specified voltage or a specified SOC.

The slicing and classification processing module is configured to subject data of the obtained discharge capacities C₁ to slicing and classification processing according to a cut-off voltage discharge mode or subject data of the discharge endpoint voltage V₁ obtained by the data acquisition module to slicing and classification processing according to a cut-off time discharge mode, thereby ensuring consistent starting voltages and rebound times of rebound voltages for each data category.

The slicing and classification processing on the data of the obtained discharge capacities C₁ according to the cut-off voltage discharge mode is as follows.

S21. Grading trays are classified into multiple intervals according to maximum discharge capacities within the grading trays, specifically as follows. For m grading trays, a maximum discharge capacity within a 1^{st} grading tray is recorded as C₁ₘₐₓ₋₁, a maximum discharge capacity within a 2^{nd} grading tray is recorded as C₁ₘₐₓ₋₂, and so on, with a maximum discharge capacity within an m-th grading tray recorded as C₁ₘₐₓ₋ₘ. The maximum discharge capacities C₁ₘₐₓ₋₁, C₁ₘₐₓ₋₂, ..., C₁ₘₐₓ₋ₘ are arranged in a queue in ascending or descending order. By taking a head of the queue as a benchmark, grading trays with a difference of 0-x mAh from the head are classified into a first interval, grading trays with a difference of x-2x mAh from the head are classified into a second interval, and so on. In this way, there are multiple intervals. That is, the m grading trays are classified into multiple intervals according to the maximum discharge capacities within the grading trays, and a difference in the maximum discharge capacities among the grading trays within each interval is controlled within x mAh, ensuring consistency among the grading trays.

S22. The lithium-ion cells within each of the grading tray intervals generated in the step S21 are classified into multiple sub-intervals according to their capacities, specifically as follows. The grading trays each hold n lithium-ion cells. Assuming a certain interval in the step S21 includes p trays, totaling n*p lithium-ion cells. The capacity of a 1^{st} lithium-ion cell is recorded as C₁₋₁, the capacity of a 2^{nd} lithium-ion cell is recorded as C₁₋₂, and so on, with the capacity of an (n*p)-th lithium-ion cell denoted as C_{1-n*p}. The capacities C₁₋₁, C₁₋₂, ..., C_{1-n*p} are arranged in a queue in ascending or descending order. By taking a head of the queue as a benchmark, lithium-ion cells with a difference of 0-y mAh from the head are classified into a first sub-interval, lithium-ion cells with a difference of y-2y mAh from the head are classified into a second sub-interval, and so on. In this way, there are multiple sub-intervals. That is, the n*p lithium-ion cells are classified into multiple sub-intervals, and a difference in the capacities among the lithium-ion cells within each sub-interval is controlled within y mAh, ensuring consistency of individual lithium-ion cells.

The slicing and classification processing on the data of the obtained discharge endpoint voltage V₁ according to the cut-off time discharge mode is as follows. For N lithium-ion cells, the discharge endpoint voltage of a 1^{st} lithium-ion cell is recorded as V₁₋₁, the discharge endpoint voltage of a 2^{nd} lithium-ion cell is recorded as V₁₋₂, and so on, with the discharge endpoint voltage of an N-th lithium-ion cell denoted as V_{1-N}. The discharge endpoint voltages are arranged in a queue in ascending or descending order. By taking a head of the queue as a benchmark, lithium-ion cells with a difference of 0-s mV from the head are classified into a first interval, lithium-ion cells with a difference of s-2s mV from the head are classified into a second interval, and so on. In this way, there are multiple intervals. That is, the N lithium-ion cells are classified into multiple intervals according to the discharge endpoint voltages, and a difference in the discharge endpoint voltages among the lithium-ion cells within each interval is controlled within s mV, ensuring consistency of the lithium-ion cells.

The prediction model construction module is configured to plot, based on the data after slicing and classification, a scatter plot of the remaining capacities C₂ against the rebound voltages V₂ according to the remaining capacities C₂ and corresponding rebound voltages V₂ of the lithium-ion cells within each interval, perform curve fitting on the scatter plot, and derive remaining capacity prediction model equations for the lithium-ion cells within each interval, where the remaining capacity prediction model equations are monomial or polynomial.

The full discharge capacity calculation module is configured to calculate full discharge capacities of a new batch of lithium-ion cells based on a remaining capacity prediction model.

The full discharge capacities of the new batch of lithium-ion cells are calculated using two methods based on the remaining capacity prediction model. A first method includes the following steps.

S41. Discharge capacities C₁ and rebound voltages V₂ of the new batch of lithium-ion cells are obtained according to the steps S11 to S14 of the grading process in the step S1.

S42. The data of the obtained discharge capacities C₁ of the new batch of lithium-ion cells is subjected to slicing and classification processing according to the step S2, and corresponding calculation equations are retrieved from the remaining capacity prediction model for each data category.

S43. The rebound voltages V₂ obtained in the step S41 are input into the calculation equations retrieved in the step S42 to acquire remaining capacities C₂ of the new batch of lithium-ion cells.

S44. An equation is derived as follows: full discharge capacity C of new-batch lithium-ion cell = discharge capacity C₁ of new-batch lithium-ion cell + remaining capacity C₂ of new-batch lithium-ion cell.

A second method includes the following steps.

S4-1. Discharge endpoint voltages V₁ and rebound voltages V₂ of the new batch of lithium-ion cells are obtained according to the steps S11 to S14 of the grading process in the step S1.

S4-2. The obtained data of the discharge endpoint voltages V₁ of the new batch of lithium-ion cells is subjected to slicing and classification processing according to the step S2, and corresponding calculation equations are retrieved from the remaining capacity prediction model for each data category.

S4-3. The rebound voltages V₂ obtained in the step S4-1 are input into the calculation equations retrieved in the step S4-2, and calculating remaining capacities C₂ of the new batch of lithium-ion cells.

S4-4. An equation is derived as follows: full discharge capacity C of new-batch lithium-ion cell = discharge capacity C₁ of new-batch lithium-ion cell + remaining capacity C₂ of new-batch lithium-ion cell.

### Embodiment 4

This embodiment provides a storage medium. The storage medium is configured to store a computer program. The computer program is executed by a processor to implement the high-efficiency grading method for lithium-ion cells in Embodiment 1 or Embodiment 2.

The foregoing embodiments are only used to explain the technical solutions of the present disclosure, and are not intended to limit the same. Although the present disclosure is described in detail with reference to the foregoing embodiments, those of ordinary skill in the art should understand that they can still modify the technical solutions described in the foregoing embodiments, or perform equivalent substitutions on some technical features therein. These modifications or substitutions do not make the essence of the corresponding technical solutions deviate from the spirit and scope of the technical solutions of the embodiments of the present disclosure.

## Claims

1. A high-efficiency grading method for lithium-ion cells, comprising following steps:
S1: Obtaining discharge capacities C₁, discharge endpoint voltages V₁, rebound voltages V₂, and remaining capacities C₂ of lithium-ion cells;
S2: subjecting data of the discharge capacities C₁ obtained in the step S1 to slicing and classification processing according to a cut-off voltage discharge mode, or subjecting data of the discharge endpoint voltages V₁ obtained in the step S1 to slicing and classification processing according to a cut-off time discharge mode, thereby ensuring consistent starting voltages and rebound times of rebound voltages for each data category;
S3: plotting, based on the data after slicing and classification, a scatter plot of the remaining capacities C₂ against the rebound voltages V₂ according to the remaining capacities C₂ and corresponding rebound voltages V₂ of the lithium-ion cells within each interval, performing curve fitting on the scatter plot, and deriving remaining capacity prediction model equations for the lithium-ion cells within each interval; and
S4: calculating full discharge capacities of a new batch of lithium-ion cells based on a remaining capacity prediction model constructed in the step S3.

2. The high-efficiency grading method for lithium-ion cells according to claim 1, wherein the S1: obtaining discharge capacities C₁, discharge endpoint voltages V₁, rebound voltages V₂, and remaining capacities C₂ of lithium-ion cells is implemented through a grading process comprising following steps:
S11: subjecting the lithium-ion cells to constant current constant voltage charging method at a rate of 0.3-1.0 C to a full state of charge (SOC);
S12: allowing the lithium-ion cells with a full SOC to rest for 3-10 min;
S13: subjecting the lithium-ion cells to constant current discharging at a rate of 0.5-1.0 C to a specified SOC, and recording the discharge capacities C₁ and the discharge endpoint voltages V₁ of the lithium-ion cells;
S14: allowing the lithium-ion cells to rest for 1-10 min, and measuring and recording voltages of the lithium-ion cells after resting as the rebound voltages V₂;
S15: subjecting the lithium-ion cells to constant current discharging at a rate of 0.5-1.0 C to a specified voltage, and recording discharge capacities of the lithium-ion cells after the discharging as the remaining capacities C₂;
S16: allowing the lithium-ion cells to rest for 5-20 min; and
S17: subjecting the lithium-ion cells after resting to constant current charging at a rate of 0.1-0.5 C to a specified voltage or a specified SOC.

3. The high-efficiency grading method for lithium-ion cells according to claim 2, wherein in the step S2, the subjecting data of the discharge capacities C₁ obtained in the step S1 to slicing and classification processing according to a cut-off voltage discharge mode comprises:
S21: classifying grading trays into multiple intervals according to maximum discharge capacities within the grading trays; and
S22: classifying the lithium-ion cells within each of the grading tray intervals generated in the step S21 into multiple sub-intervals according to capacities of the lithium-ion cells.

4. The high-efficiency grading method for lithium-ion cells according to claim 3, wherein the S21: classifying grading trays into multiple intervals according to maximum discharge capacities within the grading trays comprises: denoting, for m grading trays, a maximum discharge capacity within a 1^{st} grading tray as C₁ₘₐₓ₋₁, a maximum discharge capacity within a 2^{nd} grading tray as C₁ₘₐₓ₋₂, and so on, with a maximum discharge capacity within an m-th grading tray denoted as C₁ₘₐₓ₋ₘ; arranging the maximum discharge capacities C₁ₘₐₓ₋₁, C₁ₘₐₓ₋₂, ..., C₁ₘₐₓ₋ₘ in a queue in ascending or descending order; and classifying, by taking a head of the queue as a benchmark, grading trays with a difference of 0-x mAh from the head into a first interval, grading trays with a difference of x-2x mAh from the head into a second interval, and so on, thereby generating multiple intervals, such that the m grading trays are classified into multiple intervals according to the maximum discharge capacities within the grading trays, and a difference in the maximum discharge capacities among the grading trays within each interval is controlled within x mAh, ensuring consistency among the grading trays.

5. The high-efficiency grading method for lithium-ion cells according to claim 4, wherein the S22: classifying the lithium-ion cells within each of the grading tray intervals generated in the step S21 into multiple sub-intervals according to capacities of the lithium-ion cells comprises: calculating a total number of lithium-ion cells within a certain interval generated in the step S21 as n*p, assuming that the grading trays each hold n lithium-ion cells and the interval comprises p trays; denoting the capacity of a 1^{st} lithium-ion cell as C₁₋₁, the capacity of a 2^{nd} lithium-ion cell as C₁₋₂, and so on, with the capacity of an (n*p)-th lithium-ion cell denoted as C_{1-n*p}; arranging the capacities C₁₋₁, C₁₋₂, ..., C_{1-n*p} in a queue in ascending or descending order; and classifying, by taking a head of the queue as a benchmark, lithium-ion cells with a difference of 0-y mAh from the head into a first sub-interval, lithium-ion cells with a difference of y-2y mAh from the head into a second sub-interval, and so on, thereby generating multiple sub-intervals, such that the n*p lithium-ion cells are classified into multiple sub-intervals, and a difference in the capacities among the lithium-ion cells within each sub-interval is controlled within y mAh, ensuring consistency of individual lithium-ion cells.

6. The high-efficiency grading method for lithium-ion cells according to claim 2, wherein in the step S2, the subjecting data of the discharge endpoint voltages V₁ obtained in the step S1 to slicing and classification processing according to a cut-off time discharge mode comprises: denoting, for N lithium-ion cells, the discharge endpoint voltage of a 1^{st} lithium-ion cell as V₁₋₁, the discharge endpoint voltage of a 2^{nd} lithium-ion cell as V₁₋₂, and so on, with the discharge endpoint voltage of an N-th lithium-ion cell denoted as V_{1-N}; arranging the discharge endpoint voltages in a queue in ascending or descending order; and classifying, by taking a head of the queue as a benchmark, lithium-ion cells with a difference of 0-s mV from the head into a first interval, lithium-ion cells with a difference of s-2s mV from the head into a second interval, and so on, thereby generating multiple intervals, such that the N lithium-ion cells are classified into multiple intervals according to the discharge endpoint voltages, and a difference in the discharge endpoint voltages among the lithium-ion cells within each interval is controlled within s mV, ensuring consistency of the lithium-ion cells.

7. The high-efficiency grading method for lithium-ion cells according to claim 5, wherein the S4: calculating full discharge capacities of a new batch of lithium-ion cells based on a remaining capacity prediction model constructed in the step S3 comprises:
S41: obtaining discharge capacities C₁ and rebound voltages V₂ of the new batch of lithium-ion cells according to the steps S11 to S14 of the grading process in the step S1;
S42: subjecting data of the obtained discharge capacities C₁ of the new batch of lithium-ion cells to slicing and classification processing according to the step S2, and retrieving corresponding calculation equations from the remaining capacity prediction model for each data category;
S43: inputting the rebound voltages V2 obtained in the step S41 into the calculation equations retrieved in the step S42, and calculating remaining capacities C₂ of the new batch of lithium-ion cells; and
S44: deriving an equation as follows: full discharge capacity C of new-batch lithium-ion cell = discharge capacity C₁ of new-batch lithium-ion cell + remaining capacity C₂ of new-batch lithium-ion cell.

8. The high-efficiency grading method for lithium-ion cells according to claim 6, wherein the S4: calculating full discharge capacities of a new batch of lithium-ion cells based on a remaining capacity prediction model constructed in the step S3 comprises:
S4-1: obtaining discharge endpoint voltages V₁ and rebound voltages V₂ of the new batch of lithium-ion cells according to the steps S11 to S14 of the grading process in the step S1;
S4-2: subjecting data of the obtained discharge endpoint voltages V₁ of the new batch of lithium-ion cells to slicing and classification processing according to the step S2, and retrieving corresponding calculation equations from the remaining capacity prediction model for each data category;
S4-3: inputting the rebound voltages V₂ obtained in the step S4-1 into the calculation equations retrieved in the step S4-2, and calculating remaining capacities C₂ of the new batch of lithium-ion cells; and
S4-4: deriving an equation as follows: full discharge capacity C of new-batch lithium-ion cell = discharge capacity C₁ of new-batch lithium-ion cell + remaining capacity C₂ of new-batch lithium-ion cell.

9. The high-efficiency grading method for lithium-ion cells according to claim 1, wherein in the step S3, the remaining capacity prediction model equations are monomial or polynomial.

10. The high-efficiency grading method for lithium-ion cells according to claim 1, wherein the lithium-ion cell comprises a lithium iron phosphate (LFP) cell and a nickel cobalt manganese (NCM) cell in terms of cell composition, and comprises a square cell, a cylindrical cell, and a pouch cell in terms of cell type.

11. A high-efficiency grading system for lithium-ion cells, comprising: a data acquisition module, a slicing and classification processing module, a prediction model construction module, and a full discharge capacity calculation module, wherein
the data acquisition module is configured to acquire discharge capacities C₁, discharge endpoint voltages V₁, rebound voltages V₂, and remaining capacities C₂ of lithium-ion cells;
the slicing and classification processing module is configured to subject data of the obtained discharge capacities C₁ to slicing and classification processing according to a cut-off voltage discharge mode or subject data of the discharge endpoint voltage V₁ obtained by the data acquisition module to slicing and classification processing according to a cut-off time discharge mode, thereby ensuring consistent starting voltages and rebound times of rebound voltages for each data category;
the prediction model construction module is configured to plot, based on the data after slicing and classification, a scatter plot of the remaining capacities C₂ against the rebound voltages V₂ according to the remaining capacities C₂ and corresponding rebound voltages V₂ of the lithium-ion cells within each interval, perform curve fitting on the scatter plot, and derive remaining capacity prediction model equations for the lithium-ion cells within each interval; and
the full discharge capacity calculation module is configured to calculate full discharge capacities of a new batch of lithium-ion cells based on a remaining capacity prediction model.

12. The high-efficiency grading system for lithium-ion cells according to claim 11, wherein the data acquisition module is configured to acquire the discharge capacities C₁, the discharge endpoint voltages V₁, the rebound voltages V₂, and the remaining capacities C₂ of the lithium-ion cells through a grading process comprising following steps:
S11: subjecting the lithium-ion cells to constant current constant voltage charging method at a rate of 0.3-1.0 C to a full SOC;
S12: allowing the lithium-ion cells with a full SOC to rest for 3-10 min;
S13: subjecting the lithium-ion cells to constant current discharging at a rate of 0.5-1.0 C to a specified SOC, and recording the discharge capacities C₁ and the discharge endpoint voltages V₁ of the lithium-ion cells;
S14: allowing the lithium-ion cells to rest for 1-10 min, and measuring and recording voltages of the lithium-ion cells after resting as the rebound voltages V₂;
S15: subjecting the lithium-ion cells to constant current discharging at a rate of 0.5-1.0 C to a specified voltage, and recording discharge capacities of the lithium-ion cells after the discharging as the remaining capacities C₂;
S16: allowing the lithium-ion cells to rest for 5-20 min; and
S17: subjecting the lithium-ion cells after resting to constant current charging at a rate of 0.1-0.5 C to a specified voltage or a specified SOC.

13. The high-efficiency grading system for lithium-ion cells according to claim 12, wherein the slicing and classification processing module is configured to subject data of the obtained discharge capacities C₁ to the slicing and classification processing according to the cut-off voltage discharge mode through following steps:
S21: classifying grading trays into multiple intervals according to maximum discharge capacities within the grading trays, specifically as follows: denoting, for m grading trays, a maximum discharge capacity within a 1^{st} grading tray as C₁ₘₐₓ₋₁, a maximum discharge capacity within a 2^{nd} grading tray as C₁ₘₐₓ₋₂, and so on, with a maximum discharge capacity within an m-th grading tray denoted as C₁ₘₐₓ₋ₘ; arranging the maximum discharge capacities C₁ₘₐₓ₋₁, C₁ₘₐₓ₋₂, ..., C₁ₘₐₓ₋ₘ in a queue in ascending or descending order; and classifying, by taking a head of the queue as a benchmark, grading trays with a difference of 0-x mAh from the head into a first interval, grading trays with a difference of x-2x mAh from the head into a second interval, and so on, thereby generating multiple intervals, such that the m grading trays are classified into multiple intervals according to the maximum discharge capacities within the grading trays, and a difference in the maximum discharge capacities among the grading trays within each interval is controlled within x mAh, ensuring consistency among the grading trays; and
S22: classifying the lithium-ion cells within each of the grading tray intervals generated in the step S21 into multiple sub-intervals according to capacities of the lithium-ion cells, specifically as follows: calculating a total number of lithium-ion cells within a certain interval generated in the step S21 as n*p, assuming that the grading trays each hold n lithium-ion cells and the interval comprises p trays; denoting the capacity of a 1^{st} lithium-ion cell as C₁₋₁, the capacity of a 2^{nd} lithium-ion cell as C₁₋₂, and so on, with the capacity of an (n*p)-th lithium-ion cell denoted as C_{1-n*p}; arranging the capacities C₁₋₁, C₁₋₂, ..., C_{1-n*p} in a queue in ascending or descending order; and classifying, by taking a head of the queue as a benchmark, lithium-ion cells with a difference of 0-y mAh from the head into a first sub-interval, lithium-ion cells with a difference of y-2y mAh from the head into a second sub-interval, and so on, thereby generating multiple sub-intervals, such that the n*p lithium-ion cells are classified into multiple sub-intervals, and a difference in the capacities among the lithium-ion cells within each sub-interval is controlled within y mAh, ensuring consistency of individual lithium-ion cells.

14. The high-efficiency grading system for lithium-ion cells according to claim 12, wherein the slicing and classification processing module is configured to subject data of the obtained discharge endpoint voltages V₁ to the slicing and classification processing according to the cut-off time discharge mode through following steps: denoting, for N lithium-ion cells, the discharge endpoint voltage of a 1^{st} lithium-ion cell as V₁₋₁, the discharge endpoint voltage of a 2^{nd} lithium-ion cell as V₁₋₂, and so on, with the discharge endpoint voltage of an N-th lithium-ion cell denoted as V_{1-N}; arranging the discharge endpoint voltages in a queue in ascending or descending order; and classifying, by taking a head of the queue as a benchmark, lithium-ion cells with a difference of 0-s mV from the head into a first interval, lithium-ion cells with a difference of s-2s mV from the head into a second interval, and so on, thereby generating multiple intervals, such that the N lithium-ion cells are classified into multiple intervals according to the discharge endpoint voltages, and a difference in the discharge endpoint voltages among the lithium-ion cells within each interval is controlled within s mV, ensuring consistency of the lithium-ion cells.

15. The high-efficiency grading system for lithium-ion cells according to claim 13, wherein the full discharge capacities of the new batch of lithium-ion cells are calculated based on the remaining capacity prediction model through following steps:
S41: obtaining discharge capacities C₁ and rebound voltages V₂ of the new batch of lithium-ion cells according to the steps S11 to S14 of the grading process in the step S1;
S42: subjecting data of the obtained discharge capacities C₁ of the new batch of lithium-ion cells to slicing and classification processing according to the step S2, and retrieving corresponding calculation equations from the remaining capacity prediction model for each data category;
S43: inputting the rebound voltages V2 obtained in the step S41 into the calculation equations retrieved in the step S42, and calculating remaining capacities C₂ of the new batch of lithium-ion cells; and
S44: deriving an equation as follows: full discharge capacity C of new-batch lithium-ion cell = discharge capacity C₁ of new-batch lithium-ion cell + remaining capacity C₂ of new-batch lithium-ion cell.

16. The high-efficiency grading system for lithium-ion cells according to claim 14, wherein the full discharge capacities of the new batch of lithium-ion cells are calculated based on the remaining capacity prediction model through following steps:
S4-1: obtaining discharge endpoint voltages V₁ and rebound voltages V₂ of the new batch of lithium-ion cells according to the steps S11 to S14 of the grading process in the step S1;
S4-2: subjecting data of the obtained discharge endpoint voltages V₁ of the new batch of lithium-ion cells to slicing and classification processing according to the step S2, and retrieving corresponding calculation equations from the remaining capacity prediction model for each data category;
S4-3: inputting the rebound voltages V₂ obtained in the step S4-1 into the calculation equations retrieved in the step S4-2, and calculating remaining capacities C₂ of the new batch of lithium-ion cells; and
S4-4: deriving an equation as follows: full discharge capacity C of new-batch lithium-ion cell = discharge capacity C₁ of new-batch lithium-ion cell + remaining capacity C₂ of new-batch lithium-ion cell.

17. A storage medium, configured to store a computer program, wherein the computer program is executed by a processor to implement the high-efficiency grading method for lithium-ion cells according to any one of claims 1 to 10.
